(19) Europäisches Patentamt
European Patent Office
Office européen des brevets

(11) EP 1 905 792 B1

(12) **EUROPEAN PATENT SPECIFICATION**

(45) Date of publication and mention of the grant of the patent:
**24.10.2012 Bulletin 2012/43**

(21) Application number: **06768157.7**

(22) Date of filing: **12.07.2006**

(51) Int Cl.:
***C08G 65/26*** *(2006.01)*
***B65D 65/38*** *(2006.01)*
***C08G 65/18*** *(2006.01)*
***C09D 11/10*** *(2006.01)*
***G09F 3/04*** *(2006.01)*
***B65B 53/00*** *(2006.01)*
***C08G 59/02*** *(2006.01)*
***C08L 83/04*** *(2006.01)*
***C09D 163/00*** *(2006.01)*

(86) International application number:
**PCT/JP2006/313893**

(87) International publication number:
**WO 2007/007803 (18.01.2007 Gazette 2007/03)**

(54) **ACTINIC-ENERGY-RAY-CURABLE RESIN COMPOSITION FOR PLASTIC FILM AND PLASTIC LABEL**

MIT AKTINISCHER STRAHLUNG HÄRTBARE HARZZUSAMMENSETZUNG FÜR KUNSTSTOFFFOLIE UND KUNSTSTOFFETIKETT

COMPOSITION DE RESINE DURCISSABLE PAR RAYONS ACTINIQUES POUR FILMS ET ETIQUETTES PLASTIQUES

(84) Designated Contracting States:
**DE FR GB**

(30) Priority: **13.07.2005 JP 2005204435**
**13.06.2006 JP 2006163819**

(43) Date of publication of application:
**02.04.2008 Bulletin 2008/14**

(73) Proprietor: **Fuji Seal International, Inc.**
**Osaka-shi,**
**Osaka 532-0003 (JP)**

(72) Inventors:
- **SHINTANI, Akira**
**c/o Nabari Factory, Fuji Seal, Inc**
**Nabari-shi, Mie 5180605 (JP)**
- **MIYAZAKI, Akira**
**c/o Nabari Factory, Fuji Seal, Inc**
**Nabari-shi Mie 5180605 (JP)**
- **ARAI, Suguru**
**c/o Nabari Factory, Fuji Seal, Inc.,**
**Nabari-shi, Mie 5180605 (JP)**
- **DOBASHI, Hidenori**
**Nabari Factory, Fuji Seal, Inc.**
**Nabari-shi, Mie 5180605 (JP)**

(74) Representative: **Grünecker, Kinkeldey,**
**Stockmair & Schwanhäusser**
**Leopoldstrasse 4**
**80802 München (DE)**

(56) References cited:
**EP-A1- 1 153 905**
**EP-A2- 0 415 243**
**JP-A- 11 349 895**
**JP-A- 2002 114 937**
**JP-A- 2003 128 779**
**JP-A- 2003 147 268**
**JP-A- 2004 314 468**
**JP-A- 2005 162 962**
**JP-A- 2006 152 085**
**US-B1- 6 322 892**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 1 905 792 B1

## Description

### Technical Field

The present invention relates to the active energy ray-curable resin composition to be applied to a plastic film, and a plastic label containing a plastic film and the resin composition applied to the plastic film.

### Background Art

As containers for beverages such as tea beverages and soft drinks, widely used are plastic bottles such as polyethylene terephthalate (PET) bottles; and metallic bottles such as bottle cans. Labels such as so-called shrink labels and orientation labels are often attached to these containers. Such labels are used to indicate descriptions about contents and to impart functionalities such as decorativeness, scratch resistance, and slipperiness. The labels are composed of plastic films coated with the resin composition. The resin composition includes, for example, the coating composition such as inks.

These resin composition should have processability suitable for their respective label processing, and, after coating and curing, the resin composition should give resin layers (hereinafter also referred to as "cured layer(s)") that have such toughness as to inhibit decrease in decorativeness and functionalities due to scratch during the course of distribution of commercial products with labels. In particular, currently-used containers for beverages are often complicatedly and sophisticatedly three-dimensionally molded containers. Accordingly, requirements on processability of films, particularly shrink films, to be attached to these containers have more and more increased. For example, such films should satisfactorily follow such complicated shapes of containers. For ensuring these high processability and high toughness simultaneously, it is necessary for cured layers to have high adhesion to base films.

To apply the resin composition typically as printing inks to bases, gravure printing is generally employed. However, gravure inks generally contain large amounts of organic solvents, and these solvents must be removed by vaporization in production processes. The recovery and decomposition of these solvents are likely to be made mandatory from the viewpoint of reducing loads on the environment. Spending on new plants and equipment for the recovery and decomposition of the solvents and cost for their maintenance have therefore become new loads on the gravure printing industry. In contrast, water-based inks use no organic solvent or only small amounts of organic solvents. However, these water-based inks suffer from a low printing speed which inevitably leads to low productivity, because the water-based inks are dried more slowly than solvent-based gravure inks.

Under these circumstances, the coating composition containing epoxy compounds as base materials and using substantially no solvent has been developed. Among them, the energy ray-curable composition containing a mixture of an epoxy compound and an oxetane compound is known as the coating composition in which flexibility is imparted to a relatively fragile epoxy resin (for example, Patent Document 1). In the technique disclosed in Patent Document 1, only basic properties such as viscosity of the composition and tensile strength of the cured composition are considered, but properties in practical use, such as coatability (printability) to plastic films and curability thereon, are not considered.

As the coating composition for use as an ink, there is known the active energy ray-curable ink composition which contains a compound having an oxetane ring, a photoinitiator, and a pigment and further contains a compound having an epoxy group, a compound having a vinyl-ether group, and/or a compound having a (meth)acryloyl group (for example, Patent Document 2). The technique disclosed in Patent Document 2 still suffers from unsolved problems such that the composition does not cure sufficiently rapidly to be used in high-speed gravure printing or flexographic printing. In addition, no consideration is made on recoatability and on changes in properties upon shrinking process.

Patent Documents 3 and 4 disclose curable compositions containing oxetanes, epoxy compound and silicone compounds in combination with substantial amounts of organic solvents. Patent Document 5 relates to a cationically polymerizable coating composition containing a binder component comprising an epoxy-group containing compound, an oxetane compound and a modified dimethyl silicone oil. Patent Document 6 discloses a curable composition comprising a platinum catalyst, a Si-H functional silicon compound and a heterocyclic compound selected from the group of epoxy-functional silicones, epoxy functional acrylic polymers and monomers selected from the group consisting of oxetanes. Compositions containing a silicone-modified epoxy monomer and an epoxy compound are disclosed in Patent Document 7.

Patent Document 1: Japanese Unexamined Patent Application Publication (JP-A) No. H11-140279
Patent Document 2: Japanese Unexamined Patent Application Publication (JP-A) No. H08-143806
Patent Document 3: Japanese Unexamined Patent Application Publication (JP-A) No. 2004-314468
Patent Document 4: Japanese Unexamined Patent Application Publication (JP-A) No. 2003-147268
Patent Document 5: Japanese Unexamined Patent Application Publication (JP-A) No. H11-349895

Patent Document 6: European Patent Application Publication No. 0 415 243 A2
Patent Document 7: European Patent Application Publication No. 1 153 905 A1

Disclosure of the Invention

Problems to be Solved by the Invention

An object of the present invention is to provide the active energy ray-curable resin composition, to be applied to a plastic film, which is the resin composition containing substantially no solvent, has excellent printability (coatability) and cures satisfactorily when used typically in gravure printing to thereby attain good productivity. After coating and curing, the composition gives a cured layer that excels typically in adhesion to the plastic film, toughness, recoatability, and following capability typically upon shrinking process. Another object of the present invention is to provide a plastic label which includes a plastic film coated with the active energy ray-curable resin composition applied on the plastic film and excels typically in surface scratch resistance and crumpling resistance.

Means for Solving the Problems

After intensive investigations to achieve the objects, the present inventors have found that the resin composition having excellent properties can be obtained by compounding at least three components of an oxetane compound, an epoxy compound, and a specific silicone compound. Specifically, this resin composition has dramatically improved coatability, adhesion, and cure rate to attain excellent productivity, and, after coating and curing, gives a cured layer that excels in properties such as processability and scratch resistance. They have also found that a plastic label having these excellent properties can be obtained with the resin composition. The present invention has been made based on these findings.

Specifically, the present invention provides the active energy ray-curable resin composition for a plastic film. The composition contains an oxetane compound, an epoxy compound, and at least one silicone compound selected from the group consisting of epoxy-modified silicones, fluorine-modified silicones, amino-modified silicones, and (meth) acrylic-modified silicones.

In the present invention, the active energy ray-curable resin composition for a plastic film may contain the oxetane compound and the epoxy compound in a weight ratio of 2:8 to 8:2 and contain 0.1 to 40 parts by weight of the silicone compound to 100 parts by weight of the total amount of the oxetane compound and the epoxy compound.

In the present invention, the active energy ray-curable resin composition for a plastic film may contain 10 to 75 percent by weight of an oxetane compound, 5 to 35 percent by weight of an epoxy compound, and 0.1 to 20 percent by weight of an epoxy-modified silicone.

In the present invention, a plastic label may include a plastic film and a coating arranged on at least one side of the plastic film, in which the coating is comprised of the active energy ray-curable resin composition for a plastic film.

In the active energy ray-curable resin composition for a plastic film of the present invention, the plastic film may be a shrink film.

The plastic label of the present invention may be a shrink label, in which the plastic film is a shrink film.

Advantages

The active energy ray-curable resin composition for plastic films according to the present invention has a low viscosity and can thereby be satisfactorily applied to a plastic film typically through gravure printing or flexographic printing. They also cure rapidly, to attain higher productive efficiency of plastic labels. Because the resin composition satisfactorily adheres to plastic films, after curing, it gives cured layers that can satisfactorily follow the deformation of base films during shrinking process and excels in scratch resistance and crumpling resistance. In addition, it excels in resistance to chemicals and adhesion to another ink composition overcoated thereon (recoatability). Accordingly, the resin composition of the present invention is especially useful typically as printing inks for plastic labels. The plastic labels applied with the resin composition are especially useful as labels to be applied to glass bottles, plastic containers such as PET bottles, and metallic containers such as bottle cans.

Best Mode for Carrying Out the Invention

The active energy ray-curable resin composition for plastic films according to the present invention (hereinafter simply referred to as "the resin composition") will be illustrated in detail below.

The resin composition according to the present invention is the active energy ray-curable composition that can be cured by the action of active energy rays such as visible rays, ultraviolet rays, and electron beams. In contrast to

thermosetting resin composition, the active energy ray-curable resin composition can be suitably applied to shrink films and other bases (substrates) that are likely to deform due to heat. Of such active energy rays, the resin composition is preferably curable by the action of ultraviolet rays or near-ultraviolet rays. They may absorb rays at wavelengths of preferably 200 to 460 nm and more preferably 300 to 460 nm.

The resin composition according to the present invention contains an oxetane compound (hereinafter referred to as "Component A"), an epoxy compound (hereinafter referred to as "Component B"), and at least one silicone compound (hereinafter referred to as "Component C") selected from the group consisting of epoxy-modified silicones (silicones having epoxy group), fluorine-modified silicones, amino-modified silicones, and (meth)acrylic-modified silicones, as essential components. Advantages of the present invention may not be obtained when the composition does not contain the above-mentioned three components. The term "(meth)acrylic" as used herein indicates "acrylic" and/or "methacrylic". Silicones containing oxetanyl group and/or epoxy group are not included in Components A and B herein.

The resin composition according to the present invention preferably contains a polymerization initiator for exhibiting curability with active energy rays (hereinafter referred to as "photoinitiator"), in addition to the three components. To have other functions, they may further contain any other components such as other polymer composition, pigments, sensitizers, dispersing agents, antioxidants, flavors, deodorants, stabilizers, lubricants, and segregation inhibitors within ranges not adversely affecting advantages of the present invention.

Component A for use in the present invention is a compound having at least one oxetanyl group per molecule and can be any of monomers and oligomers. Oxetane compounds described in, for example, Japanese Unexamined Patent Application Publication (JP-A) No. H08-85775 and Japanese Unexamined Patent Application Publication (JP-A) No. H08-134405 can be used, of which compounds having one or two oxetanyl groups per one molecule are preferred. Examples of compounds having one oxetanyl group per one molecule include 3-ethyl-3-[(phenoxy)methyl]oxetane, 3-ethyl-3-(hexyloxymethyl)oxetane, 3-ethyl-3-(2-ethylhexyloxymethyl)oxetane, 3-ethyl-3-(hydroxymethyl)oxetane, 3-ethyl-3-(chloromethyl)oxetane, and 3-ethyl-3-(cyclohexyloxymethyl)oxetane. Examples of compounds having two oxetanyl groups per one molecule include 1,4-bis[[(3-ethyloxetan-3-yl)methoxy]methyl]benzene and bis[(3-ethyloxetan-3-yl)methyl] ether. Of these compounds, 3-ethyl-3-(hydroxymethyl)oxetane and bis[(3-ethyloxetan-3-yl)methyl] ether are especially preferred, from the viewpoints of suitability for coating process and curability of the resulting coated layer.

Such Components A for use in the present invention can be prepared from an oxetane alcohol and a halide such as xylene dichloride according to a known procedure. Such oxetane alcohol may be prepared from, for example, trimethylolpropane and dimethyl carbonate. An already available oxetane compound may be used as Component A. For example, products under the trade names of "ARON OXETANE OXT-101, 121, 211, 221, and 212" are commercially available from Toagosei Co., Ltd.

Component B for use in the present invention can be any of known epoxy compounds having at least one epoxy group per molecule and can be, for example, aliphatic epoxy compounds, alicyclic epoxy compounds, and aromatic epoxy compounds. Among them, compounds having glycidyl group and compounds having epoxycyclohexane ring are preferred, of which epoxy compounds having two or more epoxy groups are preferred, from the viewpoint of high reaction rates. Such aliphatic epoxy compounds include propylene glycol glycidyl ether. Examples of alicyclic epoxy compounds include 3,4-epoxycyclohexylmethyl-3',4'-epoxycyclohexanecarboxylate and bis-(3,4-epoxycyclohexyl) adipate. Examples of aromatic epoxy compounds include bisphenol-A glycidyl ether and a condensate of bisphenol-A with glycidyl ether, epichlorohydrin-modified novolak resins, and epichlorohydrin-modified cresol resins.

Components B for use in the coating composition according to the present invention can be those prepared according to common procedures such as synthetic preparation from epichlorohydrin and bisphenol-A. They are commercially available, for example, as products from Daicel Chemical Industries, Ltd. under the trade names of "Celloxide 2021", "Celloxide 2080", and "EPOLEAD GT400", and a product from The Dow Chemical Company under the trade name of "UVR6110".

The ratio (weight ratio) of Component A to Component B in the resin composition according to the present invention is preferably 2:8 to 8:2, namely, the ratio [(Component A)/(Component B)] is preferably 0.25 to 4. When the composition is applied by gravure printing or flexographic printing, the weight ratio is preferably 4:6 to 8:2, more preferably 5:5 to 8:2, and most preferably 6:4 to 8:2. Namely, the ratio [(Component A)/(Component B)] is preferably 2/3 to 4, more preferably 1 to 4, and most preferably 1.5 to 4. If the ratio (relative amount) of Component A is larger than the above range, the resulting resin composition may begin to cure slowly and may cure slowly, which results in lowered productivity, or the composition may remain uncured in a regular cure process. If the relative amount of Component B is larger than the above range, the resin composition may have an excessively large viscosity, and it may be difficult to apply the resin composition uniformly by a coating procedure such as gravure printing or flexographic printing; and termination of cure reaction may often occur to yield a cured compound having a low molecular weight, and the cured layer may become brittle.

The total amount of Component A and Component B for use in the present invention is preferably 30 to 99 percent by weight based on the total amount of the resin composition, typically for yielding satisfactory coatability and curability. In particular, when the resin composition according to the present invention is used as a clear coating composition, the total amount is preferably 60 to 99 percent by weight, and more preferably 70 to 90 percent by weight.

When the resin composition according to the present invention is used as a printing ink containing a pigment, the total amount is preferably 30 to 90 percent by weight, and more preferably 40 to 80 percent by weight.

When Component C is an epoxy-modified silicone, the content of Component A is not specifically limited. When the composition is applied, for example, according to a coating procedure such as gravure printing or flexographic printing, the content of Component A is preferably 10 to 75 percent by weight, and more preferably 20 to 70 percent by weight based on the total amount of the resin composition (coating composition). In particular, when the resin composition according to the present invention is used as a white printing ink, i.e. when the coating layer contains large amounts of additives such as pigments and lubricants, the content of Component A is preferably 20 to 40 percent by weight. When the composition is used as a clear coating ink, i.e. when the coating layer contains small amounts of additives such as pigments and lubricants, the content of Component A is preferably 50 to 70 percent by weight. If the content of Component A exceeds 75 percent by weight, the resin composition as the coating composition may begin to cure slowly, so that the composition may cure insufficiently. Thus, the resulting cured layer may be poor in thermal stability and solvent resistance. In contrast, to cure sufficiently carried out in this case, the production speed should be lowered to thereby lower the productivity. If the content of Component A is less than 10 percent by weight, termination of cure reaction may often occur, and the cured composition may thereby have a low molecular weight or the resulting cured layer (coating layer) may become brittle. In addition, the resin composition may have an excessively high viscosity, and it may be difficult to apply the composition uniformly according to a coating procedure such as gravure printing or flexographic printing.

As is mentioned above, when Component C is an epoxy-modified silicone and when the composition is applied by coating through gravure printing or flexographic printing, the content of Component B is preferably 5 to 35 percent by weight based on the total amount of the resin composition. Particularly, when the resin composition according to the present invention is used as a white printing ink, the content of Component B is preferably 5 to 25 percent by weight; and when the composition is used as a clear coating ink, the content is preferably 10 to 35 percent by weight. If the content of Component B exceeds 35 percent by weight, termination of cure reaction may often occur to give the cured composition having a low molecular weight, and the cured layer may become brittle. In addition, the resin composition may have an excessively high viscosity, and it may be difficult to apply the composition uniformly according to a coating procedure such as gravure printing or flexographic printing. If the content of Component B is less than 5 percent by weight, the resin composition may begin to cure slowly, so that the composition may cure insufficiently. Thus, the resulting cured layer may have lowered thermal stability and solvent resistance. In contrast, to cure sufficiently in this case, the production speed should be lowered to thereby lower the productivity.

Component C for use in the present invention is at least one silicone compound selected from the group consisting of epoxy-modified silicones, fluorine-modified silicones, amino-modified silicones, and (meth)acrylic-modified silicones. These silicone compounds have one or more epoxy groups, fluorine-containing substituents, amino-containing substituents, and (meth)acryloyl-containing substituents, (hereinafter these are generically referred to as "introduced substituent(s)"), respectively. Base silicones have only to be polysiloxanes having siloxane bonds in their principal chain. Examples of base silicones include dimethylsilicones with all side chains and terminals being methyl groups, methylphenylsilicones with part of side chains being phenyl groups, and methylhydrogensilicones with part of side chains being hydrogen. Among them, dimethylsilicones are preferred. The bonding position(s) of introduced substituent(s) are not particularly limited. For example, silicones may be represented by, for example, following structural formulae. More specifically, they may have introduced substituents at two terminals of principal chain (two-terminal type as represented by following Structural Formula (1)) or at one terminal (one-terminal type as represented by following Structural Formula (2)), or in side chain (side-chain type as represented by following Structural Formula (3)). The silicones may also have introduced substituents both in side chain and at one or both of terminals (two-terminals or one terminal).

[Chemical Formula 1]

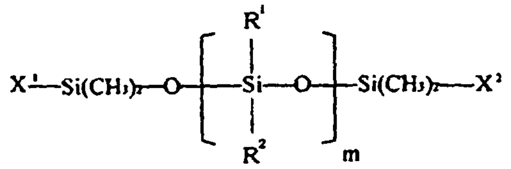

(1)

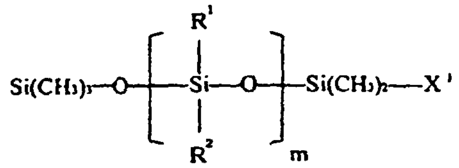

(2)

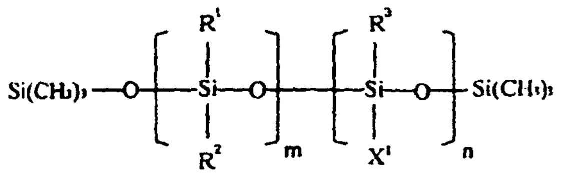

(3)

In the formulae, $X^1$ and $X^2$ are the above-mentioned introduced substituents; and each of $R^1$, $R^2$, and $R^3$ is hydrogen atom or a hydrocarbon group which may contain oxygen atom, nitrogen atom, and/or sulfur atom. These substituents are preferably hydrogen atom, methyl group, or phenyl group, and more preferably methyl group. Each of the repetition numbers "m" and "n" is an integer of 1 or more.

When Component C is a fluorine-modified silicone, the introduced substituent is not particularly limited but is preferably a fluorinated alkyl group such as a group represented by [$-R^4CF_3$], such as $-CH_2CH_2CF_3$ and $-C_3H_6CF_3$. The substituent $R^4$ is a hydrocarbon group which may contain oxygen atom, nitrogen atom, and/or sulfur atom.

The viscosity (at 23±2°C) of a fluorine-modified silicone for use as Component C in the present invention is preferably 100000 mPa · s or less, and more preferably 50000 mPa·s or less. If the viscosity exceeds 100000 mPa·s, the resin composition may have an excessively high viscosity and may not be coated satisfactorily.

When Component C is an amino-modified silicone, the introduced substituent is an amino-containing substituent, is not particularly limited, but is preferably an aminoalkyl group represented typically by [$-R^5NH_2$], [$-R^6NH-R^7NH_2$], or [$-R^9NHC_6H_{11}$], such as $-C_3H_6NH_2$ and $-C_3H_6NHC_6H_{11}$. Each of the substituents $R^5$, $R^6$, $R^7$, and $R^8$ is a hydrocarbon group which may contain oxygen atom, nitrogen atom, and/or sulfur atom.

The viscosity (23±2°C) of an amino-modified silicone for use as Component C in the present invention is preferably 100000 mPa·s or less, and more preferably 50000 mPa·s or less. If the viscosity exceeds 100000 mPa·s, the resin composition may have an excessively high viscosity and may not be coated satisfactorily.

The functional group equivalent (unit: g/mol) of an amino-modified silicone for use as Component C in the present invention may be 500 or more (for example, 500 to 60000), and more preferably 700 to 60000. If the functional group equivalent is less than 500, a cure reaction may not proceed sufficiently due to cure inhibition. If it is excessively high and exceeds 60000, the advantages of addition of Component C (improvements in adhesion and cure rate) may not be obtained effectively.

When Component C for use in the present invention is a (meth)acrylic-modified silicone, the introduced substituent is a substituent containing (meth)acryloyl group, is not particularly limited, but is preferably [$-R^9OCOCH=CH_2$] or [$-R^{10}OCOC(CH_3)=CH_2$], or the like. Specific examples thereof include $-C_3H_6OCOC(CH_3)=CH_2$ and $-C_3H_6OCOCH=CH_2$. Each of the groups $R^9$ and $R^{10}$ is a hydrocarbon group which may contain oxygen atom, nitrogen atom, and/or sulfur atom.

The functional group equivalent (unit: g/mol) of a (meth)acrylic-modified silicone for use as Component C in the present invention may be 20000 or less (for example, 50 to 20000), and is more preferably 100 to 15000. If the functional group equivalent exceeds 20000, advantages of addition of Component C may not be obtained effectively.

When Component C for use in the present invention is an epoxy-modified silicone, the introduced substituent is not particularly limited and may be, for example, represented by following structural formulae. The introduced substituent

may be one in which oxygen atom of epoxy group does not contain a cyclic aliphatic structure (left formula; hereinafter referred to as "aliphatic epoxy group") or one in which oxygen atom of epoxy group contains a cyclic aliphatic structure (right formula; hereinafter referred to as "alicyclic epoxy group").

[Chemical Formula 2]

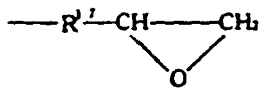

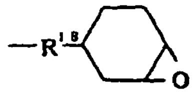

In these formulae, each of $R^{17}$ and $R^{18}$ is hydrogen atom or a hydrocarbon group which may contain oxygen atom, nitrogen atom, and/or sulfur atom. An epoxy-modified silicone compound described in Japanese Unexamined Patent Application Publication (JP-A) No. H10-259239, for example, can be used herein.

The functional group (epoxy group) equivalent (unit: g/mol) of the silicone resin is preferably 300 to 5000, and more preferably 400 to 4000, for yielding satisfactory curability.

Such epoxy-modified silicone can be obtained according to a known process. For example, it can be obtained by a process in which an alkenyl-containing epoxy compound is added to a polyorganohydrogensiloxane typically using a catalyst; a process in which an epoxy-containing hydrolyzable silane is subjected to co-hydrolysis and polycondensation with another hydrolyzable silane; or a process in which a hydroxyl-containing epoxy compound is subjected to polycondensation with a silane or siloxane having hydroxyl group or a hydrolyzable group.

Component C may further contain an organic group such as an alkyl group and/or an aralkyl group, in addition to the introduced substituents mentioned above.

Commercially available products can be used as Component C in the present invention. Examples of products as fluorine-modified silicones include products of Shin-Etsu Chemical Co., Ltd. under the trade names of "FL-5, FL-100-100cs, FL-100-450cs, FL-100-1000cs, FL-100-10000cs, X-22-821, and X-22-822", and products of Dow Corning Toray Co., Ltd. under the trade name of "FS1265". Examples of products as amino-modified silicones include products of Shin-Etsu Chemical Co., Ltd. under the trade names of "KF-8005, KF-859, KF-8008, X-22-3820W, KF-857, KF-8001, and KF-861". Examples of products as (meth)acrylic-modified silicones include methacrylic-modified silicone products of Shin-Etsu Chemical Co., Ltd. under the trade names of "X-22-2426, X-22-164A, X-22-164C, X-22-2404, and X-24-8201", acrylic-modified silicone products of Shin-Etsu Chemical Co., Ltd. under the trade names of "X-22-2445, X-22-1602", and acrylic-modified silicone products of Degussa GmbH under the trade names of "TEGO Rad 2400, 2500, 2600, and 2700". Examples of products as epoxy-modified silicones include products of Shin-Etsu Chemical Co., Ltd. under the trade names of "KF-101, KF-102, KF-105, KF-1001, X-22-163A, X-22-163B, X-22-163C, X-22-169AS, X-22-169B, X-22-173DX, and X-22-2000".

In the present invention, the amount of Component C added is preferably 0.1 to 40 parts by weight, more preferably 0.1 to 30 parts by weight, further more preferably 0.2 to 20 parts by weight, still more preferably 0.5 to 15 parts by weight, further more preferably 1 to 10 parts by weight, and most preferably 2 to 10 parts by weight, to 100 parts by weight of the total amount of Component A and Component B. If the amount of Component C is less than 0.1 part by weight, advantages of addition of Component C may be insufficient, and cure may proceed at a lower rate and the resulting resin layer may have lowered adhesion and toughness. If the amount exceeds 40 parts by weight, advantages of addition of Component A and Component B may not be exhibited effectively, or the resin composition may have an excessively high viscosity and may not be coated satisfactorily, thus causing, for example, grazing (poor print quality) during printing.

Although being not particularly limited, when Component C is an epoxy-modified silicone and the composition is applied by coating through gravure printing or flexographic printing, the content of Component C is preferably 0.1 to 20 percent by weight, more preferably 0.2 to 10 percent by weight, and further more preferably 0.3 to 5 percent by weight, based on the total amount of the resin composition (the coating composition). If the content of Component C is less than 0.1 percent by weight, advantages of addition of Component C may be insufficient, and properties such as solvent resistance, slipperiness, and water repellency may be lowered. If the content exceeds 20 percent by weight, the resin composition may have an excessively high viscosity, and it may be difficult to apply the composition uniformly by gravure printing or flexographic printing.

In the present invention, Component A is characterized by giving a tough cured layer having a high molecular weight, because this component is resistant to termination of cure reaction. However, this component is also resistant to initiation of cure reaction and thereby the curing process spends a long time to give insufficient productivity. Alternatively, if the resin composition for the resin layer is subjected to cure in a short time, it does not sufficiently cure and gives a cured layer having insufficient toughness. In contrast, on Component B, initiation of cure reaction is rapidly carried out

to thereby increase a production rate. However, termination of cure often occurs, and the resulting cured composition as a cured layer has a low molecular weight and thereby has insufficient toughness. If the resin composition contains the two components A and B, it may cure somewhat rapidly and have productivity and toughness to some extent, but it is impossible to yield a cured layer having sufficient toughness when the process is conducted at a high speed. In contrast, when the resin composition further contains a predetermined amount of Component C according to the present invention, it cures dramatically rapidly as compared with the composition containing Component A and Component B alone. Accordingly, a resin layer can be cured rapidly upon a short time application of active energy rays, the process can be carried out at a higher speed, and the product can be obtained with improved productivity. In addition, the cured layer can have a high molecular weight and thereby have high toughness, because termination of cure is inhibited. In other words, productivity and toughness at high levels can be obtained simultaneously. It is difficult to obtain these advantages when the resin composition is a binary system containing Component C in combination with either Component A or Component B. The composition should be a ternary system.

The addition of Component C dramatically improves adhesion of the resin composition to a plastic base film. It also improves adhesion of the resin composition to another ink composition, and thereby improves recoatability when another printing ink, for example, is applied thereon.

When a regular resin composition contains silicone oil, cure inhibition generally occurs, and the composition tends to cure slowly and to adhere unsatisfactorily due to increased releasability. In contrast to these tendencies, the system according to the present invention containing the above-mentioned specific modified silicone compound cures more rapidly and adheres more satisfactorily. Although details remain unknown, the improvements in cure rate and adhesion to a plastic film, and the expression of recoatability with another ink are probably caused by interactions between the three components, i.e., Components A, B, and C. For example, the reactivity increases probably because Component C surrounds Components A and B when the composition cures upon application of active energy rays. When Component C is a fluorine-modified silicone, the adhesion and recoatability are improved probably because the fluorine-modified silicone as Component C is involved in the reaction to alter wettability.

By compounding Components A, B, and C according to the present invention, the composition can cure further rapidly to attain higher productivity. The composition gives a cured layer that has improved adhesion and toughness and can thereby satisfactorily follow the deformation of a base shrink film during shrinking process. After shrinking, the cured layer shows higher scratch resistance and crumpling resistance. In addition, the cured layer has effective properties such as resistance to chemicals, slipperiness, water repellency, oil repellency, and less odor.

The resin composition according to the present invention preferably contains a photoinitiator to exhibit curability with active energy rays. Such photoinitiators for use in the present invention are not particularly limited, of which photo-induced cationic polymerization initiators are preferred. The photo-induced cationic polymerization initiators include, but are not limited to, diazonium salts, diaryliodonium salts, triarylsulfonium salts, silanol/aluminum complexes, sulfonic acid esters, and imidosulfonates, and the like. Among them, diaryliodonium salts and triarylsulfonium salts are particularly preferred, from the viewpoint of reactivity. The content of the photoinitiator is not particularly limited, and is preferably 0.5 to 7 percent by weight, and more preferably 1 to 5 percent by weight based on the total amount of the resin composition.

When the resin composition according to the present invention is used as a printing ink composition may further contain additives such as pigments, dyestuffs, and others according to necessity. The pigments can be organic or inorganic color pigments and be selected and used according to the use. Examples such pigments include white pigments including titanium dioxide (titanium dioxide); cyan (blue) pigments such as copper phthalocyanine blue; red pigments such as condensed azo pigments; carbon blacks; aluminum flakes; and mica. In addition, extender pigments can be used as pigments for the purpose such as adjusting gloss or luster. Examples of such extender pigments include alumina, calcium carbonate, barium sulfate, silica, and acrylic beads. The content of such pigments can be freely set according typically to the types of pigments and the target density of color, but is preferably about 0.1 to about 70 percent by weight based on the total amount (total weight) of the resin composition.

Among them, titanium dioxide is preferably used as a pigment when the resin composition according to the present invention is used as a white printing ink. The titanium dioxide can be any of rutile (high-temperature tetragonal), anatase (low-temperature tetragonal), and brookite (orthorhombic) titanium dioxides. It can be obtained as commercially available products such as product as titanium dioxide particles of Ishihara Sangyo Kaisha, Ltd. under the trade name of "TIPAQUE", and products as titanium dioxide of TAYCA CORPORATION under the trade name of "JR Series". The average particle diameter of titanium dioxide particles is, for example, about 0.01 to about 1 $\mu$m, and preferably about 0.1 to about 0.5 $\mu$m. When titanium dioxide particles form an aggregate, the average particle diameter corresponds to the particle diameter of the aggregate, i.e., secondary particle diameter. If the average particle diameter is less than 0.01 $\mu$m, the composition may not be dispersed satisfactorily. If it exceeds 1 $\mu$m, the label may have a rough surface and may often have deteriorated appearance. When the resin composition according to the present invention is used as a white printing ink, the content of titanium dioxide is preferably 20 to 60 percent by weight, and more preferably 30 to 55 percent by weight based on the total amount of the resin composition. This range is set from the viewpoints of exhibiting masking ability of titanium dioxide and inhibiting coarse protrusion formations.

The resin composition according to the present invention preferably contains a sensitizer according to necessity, for yielding higher productive efficiency. This is particularly effective when the above-mentioned titanium dioxide pigment, for example, is used. The sensitizer in this case can be selected from existing sensitizers in consideration typically of the type of active energy rays to be used. Examples of sensitizers include (1) amine sensitizers including aliphatic amines, aromatic amines, and nitrogen-containing cyclic amines such as piperidine; (2) urea sensitizers such as allyl urea and o-tolylthiourea; (3) sulfur compound sensitizers such as sodium diethyldithiophosphate; (4) anthracene sensitizers; (5) nitrile sensitizers such as N,N-di-substituted p-aminobenzonitrile compounds; (6) phosphorus compound sensitizers such as tri-n-butylphosphine; (7) nitrogen compound sensitizers such as N-nitrosohydroxylamine derivatives and oxazolidine compounds; and (8) chlorine compound sensitizers such as carbon tetrachloride. Of these sensitizers, anthracene sensitizers are preferred for their high sensitizing activities. Among them, thioxanthone and 9,10-dibutoxyanthracene are more preferred. The content of such sensitizers is not particularly limited, but is preferably 0.1 to 5 percent by weight, and particularly preferably 0.3 to 3 percent by weight based on the total amount of the resin composition.

The resin composition according to the present invention may contain lubricants according to necessity. Examples of lubricants herein include waxes of every kind, including polyolefin waxes such as polyethylene waxes; aliphatic amides; aliphatic esters; paraffin wax; polytetrafluoroethylene (PTFE) wax; and carnauba wax.

When the resin composition according to the present invention contains a solvent which is not involved in reactions and is used mainly as a dispersing agent, the content of the solvent is 5 percent by weight or less, and preferably 1 percent by weight or less. Most preferably, the composition does not substantially contain a solvent. Examples of the solvent as used herein include organic solvents such as toluene, xylenes, methyl ethyl ketone, ethyl acetate, methyl alcohol, and ethyl alcohol; and water. These solvents are generally used typically in inks for gravure printing or flexographic printing to improve coating processability, and compatibility and dispersibility of respective components in the coating composition (printing inks). Reactive diluents to be contained in the resin composition after curing the resin composition are not included in the solvents as defined herein. The resin composition according to the present invention can exhibit excellent coatability and dispersibility among components even when no solvent is contained. This minimizes the amount of such a solvent and eliminates the need of removing the solvent. Accordingly, a cured layer can be prepared at a higher speed and lower cost, and loads on the environment can be reduced.

The viscosity (23±2°C) of the resin composition according to the present invention is not particularly limited. When the composition is to be applied by gravure printing, the viscosity is preferably 10 to 2000 mPa·s, and more preferably 20 to 1000 mPa·s. If the viscosity exceeds 2000 mPa·s, the composition may not be applied by gravure printing satisfactorily, thereby cause, for example, "grazing", and this lowers decorating properties. If the viscosity is less than 10 mPa·s, the composition may become unstable during storage, and pigments and additives, for example, may be likely to sink down. The viscosity of the resin composition can be controlled by adjusting compounding ratios of Components A, B, and C, and/or by using a thickening agent or a thinning agent. The term "viscosity" as used herein means a value measured according to the method specified in Japanese Industrial Standards (JIS) Z 8803 with a Brookfield type viscometer (single-cylinder rotary viscometer) at 23±2°C and 60 rotate per minutes, unless otherwise specified.

The resin composition according to the present invention is preferably applied through gravure printing, flexographic printing, or ink-jet printing from the viewpoints typically of cost, productivity, and decorativeness of the printed resin layer. In particular, the resin composition is preferably applied through gravure printing.

The resin composition according to the present invention can be used as printing inks for imparting decorativeness; as clear coating composition (slippery vanishes) for improving slipperiness of surface of labels; and as matt coating composition (mat varnishes) for matt labels. Cured layers prepared from the resin composition according to the present invention have excellent scratch resistance and are suitably used typically as an outermost layer (surface of top layer opposite to an adherend such as a container) of labels such as a surface print or surface medium. In addition, they have good recoatability and are also suitable as an underlayer when two or more ink layers are laminated.

The resin composition according to the present invention may be used for plastic labels. More specifically, they can be used for, for example, orientation labels, shrink labels, orientation/shrink labels, in-mold labels, tack labels, roll labels (rolled stick-on labels), and heat-sensitive adhesive labels. Among them, the resin composition according to the present invention is particularly preferably used for shrink labels, because the composition after curing adheres satisfactorily and shows excellent following capability during shrinking process.

A plastic label having a cured layer (also referred to as "coating layer") according to the present invention can be obtained by applying the resin composition according to the present invention to at least one side of a plastic film and curing the composition with active energy rays. In the present invention, the cured layer may be arranged in the label as a top surface layer, such as an outermost layer or innermost layer, or as an underlayer underlying another ink layer. When the cured layer is used as a top surface layer, it effectively imparts properties such as scratch resistance, surface thermal stability, solvent resistance, and water repellency to the label. If the layer is used as an underlayer, it effectively prevents delamination of another ink which has been overcoated thereon. In particular, the cured layer is preferably used for the formation of a shrink label, because the cured layer shows good adhesion and satisfactory

following capability during shrinking process, and this effectively inhibit whitening, delamination, and cracks (ink cracks) caused by shrinkage.

The type of a plastic film for use in a plastic label according to the present invention can be selected as appropriate according typically to required properties, use, and cost, and is not particularly limited. Examples of usable plastic films include films of resins such as polyesters, polyolefins, polystyrenes, poly(vinyl chloride)s, polyamides, aramid resins, polyimides, polyphenylenesulfides, and acrylic resins. Among them, preferred are polyester films, polyolefin films, polystyrene films, and poly(vinyl chloride) films, of which polyester films and polyolefin films are more preferred. The material polyester can be, for example, a poly(ethylene terephthalate) (PET) or poly(ethylene-2,6-naphthalenedicarboxylate) (PEN). The material polyolefin can be, for example, polypropylene, polyethylene, or a cyclic olefin.

The plastic film may be a single-layer film or a multilayer film including two or more film layers arranged according typically to required properties and use. When the plastic film is a multilayer film, it may be a multilayer film including film layers composed of different resins. The multilayer film can be, for example, three-layered film including a central layer and two surface layers (inner layer and outer layer), in which the central layer is composed of a polyolefin resin or a polystyrene resin, and the surface layers are composed of a polyester resin. The plastic film can be any of an unoriented film, a uniaxially oriented film, and a biaxially oriented film, selected according typically to required properties and use. In particular, when the plastic label is a shrink label, the plastic film is often a uniaxially or biaxially oriented film, of which generally used is a film which has strong orientation in a film width direction (direction to be a circumferential direction of the label), namely, a film which has been substantially uniaxially oriented in a widthwise direction.

The plastic film can be prepared according to a common procedure such as film formation using melting state or film formation using solution. A commercially available plastic film can also be used herein. The plastic film may have a surface which has been subjected to a common surface treatment such as corona discharge treatment or treatment with a primer, if necessary.

A polyester film such as a PET film may be prepared by film formation using melting state, for example, in the following manner. A material for the film is polymerized according to a known procedure. A polyester, for example, may be prepared by a process in which terephthalic acid and ethylene glycol as starting materials are subjected to direct esterification to yield a low molecular weight poly(ethylene terephthalate), and this is further subjected to polycondensation by the catalysis typically with antimony trioxide to yield a polymer. Where necessary, another monomer such as 1,4-cyclohexanedimethanol may be copolymerized. The material thus obtained is extruded from a T-die through a single-screw or double-screw extruder to thereby yield an unoriented film. In this case, an unoriented multilayer film having layers of different kinds of resins can be obtained, for example, through coextrusion. The unoriented film is generally subjected to orientation to yield a plastic film, while the processes vary with the use. The orientation may be biaxial orientation in a longitudinal direction (machine direction (MD)) and a widthwise direction (transverse direction (TD)) or monoaxial orientation in a longitudinal or widthwise direction. The orientation procedure can be any of orientation using a roll, orientation using a tenter, and orientation using a tube. While depending on the type of a polymer to be used, the orientation procedure of a plastic film, for example, if used for the preparation of a shrink label, is often conducted by orientation the film at a temperature between the glass transition temperature (Tg) of the polymer and a temperature about 50°C higher than the glass transition temperature (Tg+50°C) in a longitudinal direction, for example, at a orientation ratio of about 1.01 to about 3 times, and preferably about 1.05 to about 1.5 times and then orientation in a widthwise direction at a orientation ratio of about 3 to about 10 times, and preferably about 4 to about 6 times, if the need arises.

The rate of thermal shrinkage (90°C, 10 seconds) of the plastic film is not particularly limited. When the plastic film is used for the preparation of a shrink label, the plastic film preferably has a thermal shrinkage of -3% to 15% in a longitudinal direction and of 20% to 80% in a widthwise direction.

The thickness of the plastic film may vary depending on its use, is not particularly limited, but is preferably 10 to 200 μm. When the plastic film is used for the preparation of a shrink label, for example, the thickness is preferably 20 to 80 μm, and more preferably 30 to 60 μm.

The thickness of a resin layer formed by the application of the resin composition according to the present invention may vary depending on its use, is not particularly limited, but is preferably 0.1 to 15 μm, and especially preferably 0.5 to 10 μm. It may be difficult to form a uniform resin layer when the resin layer has a thickness of less than 0.1 μm. If the resulting uneven resin layer is used, for example, as a print layer, it may have deteriorated decorativeness or may not be printed in accordance with the design due typically to partial "grazing". In contrast, when the resin layer has a thickness exceeding 15 μm, a large amount of the resin composition may be required, and this may invite increased cost, or it may be difficult to apply the composition to form a uniform resin layer. Alternatively or in addition, the resulting cured layer may be brittle and be likely to delaminate. In particular, when the cured layer is a white ink layer, the thickness of the resin layer is preferably 3 to 10 μm for achieving sufficient masking. When the cured layer is a clear coating layer, the thickness is preferably 0.2 to 3 μm, for yielding satisfactory transparency. It should be noted that the cured layer formed according to the present invention varies little in its thickness before and after cure.

Cured layers obtained according to the present invention can be used as various layers, such as print ink layers, topcoat layers, and anchor coat layers. Particularly, they can exhibit excellent advantages when used as surface print

ink layers and topcoat layers requiring scratch resistance, and as anchor coat layers underlying another ink layer.

The angle of contact between water and a surface of a cured layer of a plastic label according to the present invention is not particularly limited, but is preferably 90 degrees or more, and more preferably 100 degrees or more. If the angle of contact between water and the cured layer is less than 90 degrees, the surface of the cured layer may be likely to be soiled.

A plastic label according to the present invention may further have another print layer in addition to a cured layer formed according to the present invention. In this case, such another print layer can be formed according to a common printing procedure such as gravure printing or flexographic printing. A printing ink for use in the formation of the print layer contains, for example, a pigment, a binder resin, and a solvent. Examples of the binder resin include common or regular resins such as acrylic resins, urethane resins, polyamides, vinyl chloride-vinyl acetate copolymers, celluloses, and nitrocelluloses. The thickness of the print layer is not particularly limited and is, for example, about 0.1 to about 10 μm.

A plastic label according to the present invention may further contain one or more other layers in addition to the cured layer formed according to the present invention. Examples of such other layers include anchor coat layers, primer coat layers, layers of nonwoven fabrics, and layers of paper.

Plastic labels according to the present invention are generally used as labeled containers after being affixed to containers. Examples of such containers include soft drink bottles such as PET bottles; home-delivered milk containers; containers for foodstuffs such as seasonings; alcoholic drink bottles; containers for pharmaceutical preparations; containers for chemicals such as detergents and aerosols (sprays); and pot noodle containers. Materials for these containers include plastics such as PET; glass; and metals. Plastic labels according to the present invention may also be used to be applied to other adherends than containers.

Some embodiments of how the resin composition and plastic labels according to the present invention are prepared, and how the plastic labels are attached to containers will be illustrated below. In the following embodiments, a shrink film that shrinks in a widthwise direction is used as a plastic film to prepare a cylindrical shrink label. It should be noted, however, this is illustrated only by way of example, and the ways how the composition and plastic labels are prepared and how the plastic labels are attached to containers are not limited thereto.

In the following illustrations, the term "plastic film" refers to an original film before bearing a cured layer; the term "(long) plastic label" refers to the plastic film bearing a cured layer formed according to the present invention. In the attachment of the label to a container, the term "long cylindrical plastic label" refers to the long plastic label which has been processed to be cylindrical while leaving it long.

[Preparation of Resin Composition]

Above-mentioned Component A, Component B, Component C, and a photoinitiator are mixed to yield the resin composition. Additives such as pigments and sensitizers, if used, are also mixed simultaneously with the above components. The mixing is conducted typically using a mixer, a mill, and/or a kneader. Examples of the mixer include butterfly mixers, planetary mixers, pony mixers, dissolvers, tank mixers, homomixers, and homodispers. Examples of mills include roll mills, sand mills, ball mills, bead mills, and line mills. The mixing duration (residual duration) in the mixing is preferably 10 to 120 minutes. Where necessary, the resulting resin composition may be filtrated before use.

[Preparation of Plastic Label]

A resin layer (before cure) is formed by coating the resin composition according to the present invention to a plastic film typically through gravure, flexographic, or ink-jet printing. The coating may be conducted by in-line coating in which the composition is applied during the preparation of the plastic film, for example, before orientation (as an unorientated film) or after monoaxial orientation in a machine direction; or by off-line coating in which the composition is applied after the preparation of the plastic film. The coating procedure is not particularly limited, but off-line coating is preferred from the viewpoints of productivity and processability including cure processability.

Next, curing of the resin layer is conducted. The curing is preferably conducted in a series of steps including the coating step, from the viewpoint of productivity. The curing is conducted by the irradiation with an active energy ray using an ultraviolet (UV) lamp, an ultraviolet LED, or ultraviolet laser, or the like. The active energy ray to be applied may vary depending on the composition of the resin composition, is not particularly limited, but is preferably ultraviolet rays (near-ultraviolet rays) having wavelengths of 200 to 460 nm (more preferably 300 to 460 nm), from the viewpoint of curability. The irradiation is preferably conducted at an irradiation intensity of 150 to 1000 mJ/$cm^2$ for a irradiation time of 0.1 to 3 seconds.

The long plastic label thus obtained is slit to predetermined widths, and wound to yield rolls.

[Processing of Long Plastic Label]

Next, one of the rolls is unwound and formed into a round cylinder so that a widthwise direction of the long plastic film stands a circumferential direction of the cylinder. Specifically, the long plastic label is formed into a cylinder, and a solvent, such as tetrahydrofuran (THF), and an adhesive (these components are hereinafter referred to as "solvent and other components") are applied in a swath about 2 to 4 mm wide in a longitudinal direction to an inner surface of one lateral end of the label. The label is then cylindrically wound so that the portion where the solvent and other components are applied is overlaid the outer surface of the other lateral end of the label at a position of 5 to 10 mm inside from the other lateral end, affixed and adhered (center-sealed). Thus, a long cylindrical plastic label is obtained as a continuous long cylindrical plastic label. It is desirable that no cured layer is arranged in the portion where the solvent and other components are applied and are subjected to adhesion.

When perforations for tearing the label are arranged, perforations with predetermined lengths and intervals (pitches) are formed in a longitudinal direction. The perforations can be arranged according to a common procedure. They can be arranged, for example, by pressing a disk-like blade peripherally having cutting edges and non-cutting portions alternately, or by using laser. The step of arranging perforations can be carried out as appropriate in a suitable stage, such as after the printing step, or before or after the step of processing to form a cylindrical label.

[Labeled Container]

Finally, the above-prepared long cylindrical plastic label is cut, attached to a predetermined container, shrunk by heat treatment, thereby brought into intimate contact with the container, and yields a labeled container. More specifically, the long cylindrical plastic label is fed to an automatic labeling machine (shrink labeler), cut to a required length, fit onto a container filled with a content, subjected to thermal shrinkage by allowing the article to pass through a hot-air tunnel or steam tunnel at a predetermined temperature or by heating the article with radial heat such as infrared rays, thereby brought into intimate contact with the container, and thus yields a labeled container. The heat treatment may be carried out, for example, by treating the article with steam at 80°C to 100°C. For example, the article may be allowed to pass through a heating tunnel filled with steam.

EXAMPLES

The present invention will be illustrated in further detail with reference to several examples below. Methods for measuring properties and methods for evaluating advantageous effects in the present invention including the following examples are as follows.

[Methods for Measuring Properties and Evaluating Advantages]

(1) Gravure Printability

Gravure printing was carried out under printing conditions in examples and comparative examples, and how are the resulting prints were visually observed. A sample having a print in exact accordance with the printing cylinder was evaluated as having good gravure printability (○), and a sample having a print not in accordance with the printing cylinder was evaluated as having poor gravure printability (×).

(2) Curability (Initial Tack)

Curing was conducted at a process speed in ultraviolet irradiation of 50, 70, or 100 m/minute in the examples and comparative examples. The surfaces of cured layers were touched by a finger immediately after curing, and whether or not the ink was attached to the finger was visually observed. The curability was evaluated according to the following criteria:

◎: The ink was not attached at a process speed of 100 m/minute;
○: The ink was not attached at a process speed of 70 m/minute, but was attached at a process speed of 100 m/minute;
Δ: The ink was not attached at a process speed of 50 m/minute, but was attached at a process speed of 70 m/minute;
×: The ink was attached even at a process speed of 50 m/minute.

(3) Adhesion (Tape Peeling Test)

Tests were conducted according to JIS K 5600, except for not forming cross cuts. NICHIBAN tapes (18 mm

wide) were affixed to surfaces of resin layers of plastic labels prepared according to the examples and comparative examples, were peeled off at an angle of 90 degrees, the areas of residual resin layers were observed in regions each 5 mm wide and 5 mm long, and the adhesion was evaluated according to the following criteria:

90% or more: Good adhesion (○);
80% or more and less than 90%: Somewhat poor but usable adhesion (Δ) ;
Less than 80%: Poor adhesion (×)

(4) Crumpling Resistance

Sample pieces 100 mm long and 100 mm wide were sampled from plastic labels prepared according to the examples and comparative examples. The sample pieces were held by both hands at both ends, and crumpled ten times by both hands. The areas of residual cured layers on the surfaces of the crumpled sample pieces were visually observed, and the crumpling resistance was evaluated as follows. A sample showing a residual area of 90% or more was evaluated as having good crumpling resistance (○), and one showing a residual area of less than 90% was evaluated as having poor crumpling resistance (×).

(5) Scratch Resistance

Sample pieces 100 mm long and 100 mm wide were sampled from plastic labels prepared according to the examples and comparative examples. The sample pieces were placed on a flat table, the surfaces of the sample pieces on the side bearing a cured layer were rubbed with the back of a finger nail ten times in back-and-forth motion in a region of 20 mm in a longitudinal direction, the surfaces were then observed, and the scratch resistance was evaluated according to the following criteria:

The cured layer was not at all delaminated: Good scratch resistance (○) ;
The cured layer was partially delaminated: Somewhat poor but usable scratch resistance (Δ);
The cured layer was remarkably delaminated: Poor scratch resistance (x)

(6) Overprintability (Recoatability on overprinting)

The each resin composition prepared according to the examples and comparative examples was overcoated by printing onto cured layers of plastic labels prepared by using the corresponding composition prepared according to the examples and comparative examples. The conditions for printing and curing were similar to the conditions for printing and curing the resin composition in the examples and comparative examples.
The adhesion of the overcoated ink layers was evaluated by the same procedure according to the same criteria as in "(3) Adhesion".

(7) Thicknesses of Film Layer and Cured layer

The thicknesses of films were measured with a stylus-type thickness gauge. The thicknesses of cured layers were measured as the step height between a portion where a cured layer was arranged (coated surface) and a portion where no cured layer was arranged (non-coated surface) with a three-dimensional microscope (Keyence Corporation; VK8510).

(8) Thermal Shrinkage (90°C) of Plastic Film

Rectangular sample pieces were cut out from the plastic films in a measurement direction (longitudinal direction or widthwise direction). The sample pieces had a length of 200 mm (gauge length: 150 mm) and a width of 10 mm.
The sample pieces were subjected to heat treatment (under no load) in hot water at 90°C for 10 seconds, the differences in gauge length between before and after the heat treatment and thermal shrinkages were calculated according to the following calculation formula:

$$\text{Thermal shrinkage (\%)} = (L_0 - L_1)/L_0 \times 100$$

$L_0$: Gauge length before the heat treatment
$L_1$: Gauge length after the heat treatment

(9) Viscosity

The viscosities were measured according to JIS Z 8803 with a Brookfield type viscometer (single-cylinder rotary viscometer) supplied from Toki Sangyo Co., Ltd. at 23±2°C and 60 rotate per minutes.
Examples are shown below.

EXAMPLE 1

The active energy ray-curable resin composition (white ink) was prepared by blending, in amounts shown in Table 1, bis[(3-ethyloxetan-3-yl)methyl] ether (product of Toagosei Co., Ltd. under the trade name of "ARON OXETANE OXT-221") as Component A (A1); an epoxy monomer (product of The Dow Chemical Company under the trade name of "UVR-6110") as Component B (B1); a fluorine-modified silicone (product of Shin-Etsu Chemical Co., Ltd. under the trade name of "X-22-821") as Component C (C1); a photoinitiator (product of The Dow Chemical Company under the trade name of "UVI-6992"); titanium dioxide (product of TAYCA CORPORATION under the trade name of "JR-809") as a white pigment; and dibutoxyanthracene (product of Kawasaki Kasei Chemicals Ltd.) as a sensitizer. No solvent was used herein.
The prepared resin composition was applied to all over one side of a polyester shrink film (product of Toyobo Co., Ltd. under the trade name of "Spaceclean S7042", film thickness: 45 μm) to form a resin layer 3.6 μm thick by gravure printing at a process speed of 50 m/minute using a bench gravure printing machine (product of Nissio Gravure Co., Ltd. under the trade name of "GRAVO PROOF MINI") and a gravure cylinder with 90 lines/cm having a cell depth of 30μ m, and the gravure printability was evaluated.
Subsequently, the shrink film coated with the resin composition was irradiated with rays at 240 W/cm using an ultraviolet irradiator (product of FUSION UV SYSTEMS JAPAN K.K. under the trade name of "LIGHT HAMMER 10"; output: 75%, D bulb), and the curability was evaluated. The irradiation intensities of the irradiator were measured with the "UV Power Puck" (trade name; product of EIT Inc.) and were 50 $mJ/cm^2$ (UVC), 310 $mJ/cm^2$ (UVB), 550 $mJ/cm^2$ (UVA), and 370 $mJ/cm^2$ (UVV) at a conveyor speed (process speed) of 10 m/minute.
The adhesion, crumpling resistance, scratch resistance, and overprintability of the plastic label prepared at a conveyor speed of 50 m/minute and having a cured layer thickness of 3.6 μm were evaluated.
As is demonstrated in Table 1, the prepared resin composition excelled in gravure printability and curability, and the plastic label was good in adhesion, crumpling resistance, scratch resistance, and overprintability.

EXAMPLES 2 TO 8

A series of the resin composition and plastic labels were prepared by the procedure of Example 1, except for changing conditions such as the amounts of respective components, and the types of Component C and the pigment as shown in Table 1.
The each prepared resin composition excelled in gravure printability and curability, and the plastic labels were good in adhesion, crumpling resistance, scratch resistance, and overprintability.

COMPARATIVE EXAMPLE 1

The resin composition and a plastic label were prepared by the procedure of Example 2, except for not using Component A as shown in Table 1.
The resin composition had a high viscosity and was poor in gravure printability and curability, and the plastic label was poor in adhesion, crumpling resistance, scratch resistance, and overprintability.

COMPARATIVE EXAMPLE 2

The resin composition and a plastic label were prepared by the procedure of Example 2, except for not using Component B as shown in Table 1.
The resin composition cured slowly and was poor in productivity, and the plastic label was poor in adhesion, crumpling resistance, scratch resistance, and overprintability.

COMPARATIVE EXAMPLE 3

The resin composition and a plastic label were prepared by the procedure of Example 2, except for not using Component C as shown in Table 1.
The resin composition cured slowly and was poor in productivity, and the plastic label was poor in adhesion, crumpling

resistance, scratch resistance, and overprintability.

EXAMPLES 9 TO 16

A series of the resin composition and plastic labels were prepared by the procedure of Examples 1 to 8, except for using an amino-modified silicone as Component C and for changing conditions such as the amounts of respective components and the type of pigment as shown in Table 2.
The each resin composition excelled in gravure printability and curability, and the plastic labels were good in adhesion, crumpling resistance, scratch resistance, and overprintability.

COMPARATIVE EXAMPLES 4 AND 5

A series of the resin composition and plastic labels were prepared by the procedure of Example 10, except for not using Component A and Component B, respectively, as shown in Table 2.
The each resin composition cured slowly and was poor in productivity, and the plastic labels were poor in adhesion, crumpling resistance, scratch resistance, and overprintability. The resin composition prepared according to Comparative Example 4 was also poor in gravure printability.

EXAMPLES 17 TO 25

A series of the resin composition and plastic labels were prepared by the procedure of Examples 1 to 8, except for using a methacrylic-modified silicone or an acrylic-modified silicone, respectively, as Component C and for changing conditions such as the amounts of respective components and the type of pigment as shown in Table 3.
The each resin composition excelled in gravure printability and curability, and the plastic labels were good in adhesion, crumpling resistance, scratch resistance, and overprintability.

COMPARATIVE EXAMPLES 6 AND 7

A series of the resin composition and plastic labels were prepared by the procedure of Example 18, except for not using Component A and Component B, respectively, as shown in Table 3.
The each resin composition cured slowly and was poor in productivity, and the plastic labels were poor in adhesion, crumpling resistance, scratch resistance, and overprintability. The resin composition prepared according to Comparative Example 6 was also poor in gravure printability.

Reference EXAMPLES 26 TO 32

A series of the resin composition and plastic labels were prepared by the procedure of Examples 1 to 8, except for using a polyether-modified silicone as Component C and for changing conditions such as the amounts of respective components and the type of pigment, as shown in Table 4.

COMPARATIVE EXAMPLES 8 AND 9

A series of the resin composition and plastic labels were prepared by the procedure of Reference Example 27, except for not using Component A and Component B, respectively, as shown in Table 4.
The each resin composition cured slowly and was poor in productivity, and the plastic labels were poor in adhesion, crumpling resistance, scratch resistance, and overprintability. The resin composition prepared according to Comparative Example 8 was also poor in gravure printability.

In addition, labeled containers were prepared using the plastic labels of Examples 1 to 25 and Reference Examples 26 to 32. Specifically, the plastic labels prepared at a conveyor speed of 50 m/minute were formed into round cylinders so that the printed surface constituted an inner side, the lengths in circumferential direction of the cylinders were adjusted so that they would be attached to bodies of PET bottles with thermal shrinkage of 20%, both ends of them were fused and adhered with each other, and thereby yielded cylindrical plastic labels. The cylindrical plastic labels were attached to 500-ml PET bottles, subjected to shrinking in a steam tunnel at an atmospheric temperature of 90°C, and thereby yielded the labeled containers. The labeled containers had excellent finished quality.

[Table 1]

(Table 1)

| | | | Example 1 | Example 2 | Example 3 | Example 4 | Example 5 | Example 6 | Example 7 | Example 8 | Comp. Ex. 1 | Comp Ex. 2 | Comp Ex. 3 |
|---|---|---|---|---|---|---|---|---|---|---|---|---|---|
| Amount | Component A (oxetane compound) | A1 | 37 | 37 | 37 | 37 | 37 | 37 | 53 | 53 | 0 | 51 | 37 |
| | Component B (epoxy compound) | B1 | 16 | 16 | 16 | 16 | 16 | 16 | 24 | 24 | 51 | 0 | 16 |
| | Component C (fluorine-modified silicone) | C1 | 1 | 5 | 0.1 | 20 | | | 5 | 5 | 5 | 5 | 0 |
| | | C2 | | | | | 5 | | | | | | |
| | | C3 | | | | | | 5 | | | | | |
| | Photoinitiator | | 3 | 3 | 3 | 3 | 3 | 3 | 3 | 3 | 3 | 3 | 3 |
| | Sensitizer | | 1 | 1 | 1 | 1 | 1 | 1 | 1 | 1 | 1 | 1 | 1 |
| | Pigment (white) | | 40 | 40 | 40 | 40 | 40 | 40 | | | 40 | 40 | 40 |
| | Pigment (red) | | | | | | | | 16 | | | | |
| | Pigment (blue) | | | | | | | | | 16 | | | |
| Property | Gravure printability | | ○ | ○ | ○ | ○ | ○ | ○ | ○ | ○ | × | ○ | ○ |
| | Curability (initial tack) | | ◎ | ◎ | ○ | ○ | ◎ | ◎ | ◎ | ○ | × | × | × |
| | Adhesion (tape peeling) | | ○ | ○ | ○ | ○ | ○ | ○ | ○ | ○ | × | × | × |
| | Crumpling resistance | | ○ | ○ | ○ | ○ | ○ | ○ | ○ | ○ | × | × | × |
| | Scratch resistance | | ○ | ○ | ○ | ○ | ○ | ○ | ○ | ○ | × | × | × |
| | Overprintability | | ○ | ○ | ○ | ○ | ○ | ○ | ○ | ○ | × | × | × |

[Table 2]

(Table 2)

| | | | Example 9 | Example 10 | Example 11 | Example 12 | Example 13 | Example 14 | Example 15 | Example 16 | Comp. Ex. 4 | Comp. Ex. 5 |
|---|---|---|---|---|---|---|---|---|---|---|---|---|
| Amount | Component A (oxetane compound) | A1 | 37 | 37 | 37 | 37 | 37 | 37 | 52 | 52 | 0 | 51 |
| | Component B (epoxy compound) | B1 | 16 | 16 | 16 | 16 | 16 | 16 | 23 | 23 | 51 | 0 |
| | Component C (amino-modified silicone) | C4 | 1 | 5 | 0.1 | 20 | | | 5 | 5 | 5 | 5 |
| | | C5 | | | | | 5 | | | | | |
| | | C6 | | | | | | 5 | 5 | 5 | | |
| | Photoinitiator | | 3 | 3 | 3 | 3 | 3 | 3 | 3 | 3 | 3 | 3 |
| | Sensitizer | | 1 | 1 | 1 | 1 | 1 | 1 | 1 | 1 | 1 | 1 |
| | Pigment (white) | | 40 | 40 | 40 | 40 | 40 | 40 | | | 40 | 40 |
| | Pigment (red) | | | | | | | | 16 | | | |
| | Pigment (blue) | | | | | | | | | 16 | | |
| Property | Gravure printability | | ○ | ○ | ○ | ○ | ○ | ○ | ○ | ○ | × | ○ |
| | Curability (initial tack) | | ◎ | ◎ | ○ | ○ | ◎ | ◎ | ◎ | ○ | × | × |
| | Adhesion (tape peeling) | | ○ | ○ | ○ | ○ | ○ | ○ | ○ | ○ | × | × |
| | Crumpling resistance | | ○ | ○ | ○ | ○ | ○ | ○ | ○ | ○ | × | × |
| | Scratch resistance | | ○ | ○ | ○ | ○ | ○ | ○ | ○ | ○ | × | × |
| | Overprintability | | ○ | ○ | ○ | ○ | ○ | ○ | ○ | ○ | × | × |

[Table 3]

(Table 3)

| | | | | Example 17 | Example 18 | Example 19 | Example 20 | Example 21 | Example 22 | Example 23 | Example 24 | Example 25 | Comp. Ex. 6 | comp. Ex. 7 |
|---|---|---|---|---|---|---|---|---|---|---|---|---|---|---|
| Amount | Component A (oxetane compound) | | A1 | 37 | 37 | 37 | 37 | 37 | 37 | 37 | 53 | 53 | 0 | 51 |
| | Component B (epoxy compound) | | B1 | 16 | 16 | 16 | 16 | 16 | 16 | 16 | 24 | 24 | 51 | 0 |
| | Component C | (methacrylic-modified silicone) | C7 | 0.5 | 3 | 0.1 | 20 | | | | 3 | 3 | 3 | 3 |
| | | | C8 | | | | | 3 | | | | | | |
| | | (acrylic modified silicone) | C9 | | | | | | 3 | | | | | |
| | | | C10 | | | | | | | 3 | | | | |
| | Photoinitiator | | | 3 | 3 | 3 | 3 | 3 | 3 | 3 | 3 | 3 | 3 | 3 |
| | Sensitizer | | | 1 | 1 | 1 | 1 | 1 | 1 | 1 | 1 | 1 | 1 | 1 |
| | Pigment (white) | | | 40 | 40 | 40 | 40 | 40 | 40 | 40 | | | 40 | 40 |
| | Pigment (red) | | | | | | | | | | 16 | | | |
| | Pigment (blue) | | | | | | | | | | | 16 | | |
| Property | Gravure printability | | | ○ | ○ | ○ | ○ | ○ | ○ | ○ | ○ | ○ | × | ○ |
| | Curability (initial tack) | | | ◎ | ◎ | ○ | ○ | ◎ | ◎ | ◎ | ◎ | ○ | × | × |
| | Adhesion (tape peeling) | | | ○ | ○ | ○ | ○ | ○ | ○ | ○ | ○ | ○ | × | × |
| | Crumpling resistance | | | ○ | ○ | ○ | ○ | ○ | ○ | ○ | ○ | ○ | × | × |
| | Scratch resistance | | | ○ | ○ | ○ | ○ | ○ | ○ | ○ | ○ | ○ | × | × |
| | Overprintability | | | ○ | ○ | ○ | ○ | ○ | ○ | ○ | ○ | ○ | × | × |

[Table 4]

(Table 4)

| | | | Reference Example 26 | Reference Example 27 | Reference Example 28 | Reference Example 29 | Reference Example 30 | Reference Example 31 | Reference Example 32 | Comp. Ex. 8 | Comp. Ex. 9 |
|---|---|---|---|---|---|---|---|---|---|---|---|
| Amount | Component A (oxetane compound) | A1 | 37 | 37 | 37 | 37 | 37 | 53 | 53 | 0 | 51 |
| | Component B (epoxy compound) | B1 | 16 | 16 | 16 | 16 | 16 | 24 | 24 | 51 | 0 |
| | Component C (polyether-modified silicone) | C11 | 1 | 5 | 0.1 | | | 5 | 5 | 5 | 5 |
| | | C12 | | | | 5 | | | | | |
| | | C13 | | | | | 5 | | | | |
| | Photoinitiator | | 3 | 3 | 3 | 3 | 3 | 3 | 3 | 3 | 3 |
| | Sensitizer | | 1 | 1 | 1 | 1 | 1 | 1 | 1 | 1 | 1 |
| | Pigment (white) | | 40 | 40 | 40 | 40 | 40 | | | 40 | 40 |
| | Pigment (red) | | | | | | | 16 | | | |
| | Pigment (blue) | | | | | | | | 16 | | |
| Property | Gravure printability | | ○ | ○ | ○ | ○ | ○ | ○ | ○ | × | ○ |
| | Curability (initial tack) | | ◎ | ◎ | ○ | ◎ | ◎ | ◎ | ○ | × | × |
| | Adhesion (tape peeling) | | ○ | ○ | ○ | ○ | ○ | ○ | ○ | × | × |
| | Crumpling resistance | | ○ | ○ | ○ | ○ | ○ | ○ | ○ | × | × |
| | Scratch resistance | | ○ | ○ | ○ | ○ | ○ | ○ | ○ | × | × |
| | Overprintability | | ○ | ○ | ○ | ○ | ○ | ○ | ○ | × | × |

Components A, B, and C and other additives in Tables 1 to 4 are as follows. The amounts in these tables are indicated in unit of "part by weight".

Component A

A1: product of Toagosei Co., Ltd. under the trade name of "ARON OXETANE OXT-221"

Component B

B1: product of The Dow Chemical Company under the trade name of "UVR-6110"

Component C

C1: product of Shin-Etsu Chemical Co., Ltd. under the trade name of "X-22-821" (fluorine-modified)
C2: product of Shin-Etsu Chemical Co., Ltd. under the trade name of "FL-100-450cs" (fluorine-modified)
C3: product of Shin-Etsu Chemical Co., Ltd. under the trade name of "FL-100-1000cs" (fluorine-modified)
C4: product of Shin-Etsu Chemical Co., Ltd. under the trade name of "KF-8005" (amino-modified)
C5: product of Shin-Etsu Chemical Co., Ltd. under the trade name of "KF-859" (amino-modified)
C6: product of Shin-Etsu Chemical Co., Ltd. under the trade name of "KF-8008" (amino-modified)
C7: product of Shin-Etsu Chemical Co., Ltd. under the trade name of "X-24-8201" (methacrylic-modified)
C8: product of Shin-Etsu Chemical Co., Ltd. under the trade name of "X-22-164C" (methacrylic-modified)
C9: product of Shin-Etsu Chemical Co., Ltd. under the trade name of "X-22-2445" (acrylic-modified)
C10: product of Shin-Etsu Chemical Co., Ltd. under the trade name of "X-22-1602" (acrylic-modified)
C11: product of Shin-Etsu Chemical Co., Ltd. under the trade name of "X-22-6191" (polyether-modified)
C12: product of Shin-Etsu Chemical Co., Ltd. under the trade name of "KF-6015" (polyether-modified)
C13: product of Shin-Etsu Chemical Co., Ltd. under the trade name of "X-22-2516" (polyether-modified)

Photoinitiator: The Dow Chemical Company under the trade name of "UVI-6992"
Sensitizer: product of Kawasaki Kasei Chemicals Ltd., dibutoxyanthracene
Pigment (white): product of TAYCA CORPORATION under the trade name of "JR-809" (titanium dioxide)
Pigment (red): product of Ciba Specialty Chemicals Corporation under the trade name of "CROMOPHTAL RED 2030 (SA)" (diketopyrrolopyrrole)
Pigment (blue): product of Ciba Specialty Chemicals Corporation under the trade name of "IRGALITE BLUE BLPO" (copper phthalocyanine blue)

In addition, examples in which an epoxy-modified silicone was used as Component C, and Components A, B and/or additives were changed will be illustrated. In following Examples 33 to 40 and Comparative Examples 10 to 13, the gravure printability, curability, resistance to chemicals, water repellency, and suitability for shrinking were evaluated according to the following methods. The other properties were evaluated according to the above-mentioned methods.

[Methods for Evaluating Advantageous Effects (Examples 33 to 40 and Comparative Examples 10 to 13)]

(10) Gravure Printability

Gravure printing was carried out by using the resin composition and plastic films according to the examples and comparative examples, respectively, under the following conditions, how are the resulting prints were observed.

Apparatus: product of Nissio Gravure Co., Ltd., bench gravure printing machine "GRAVO PROOF MINI"
Gravure cylinder: 60 lines/cm, cell depth: 40 $\mu$m
Process speed: 80 m/minute and 50 m/minute

The gravure printability was evaluated based on the prints printed at a high process speed (80 m/minute) and a low process speed (50 m/minute), respectively, according to the following criteria:

The print was in exact accordance with the printing plate even at a high speed (80 m/minute): Good gravure printability (○) ;
Although grazing occurred at a high speed (80 m/minute), the print was in exact accordance with the printing cylinder at a low speed (50 m/minute): Usable gravure printability (Δ) ;

The print was not in accordance with the printing plate even at a low speed (50 m/minute): Poor gravure printability (x)

(11) Curability (Initial Tack)

Immediately after carrying out curing in the examples and comparative examples, the surfaces of cured layers (coating layers) were touched by a finger, and whether or not the ink was attached to the finger was visually observed. A sample was evaluated as having good curability (o) when the ink was not attached to the finger; and one was evaluated as having poor curability (x) when the ink was attached to the finger.

(12) Resistance to Chemicals (Solvent Resistance)

Surfaces of cured layers (coating layers) were rubbed ten times in back-and-forth motion with cotton swab impregnated with methyl ethyl ketone, and the surfaces were visually observed. A sample was evaluated as having good resistance to chemicals (o) when the ink was not dissolved. A sample was evaluated as having poor resistance to chemicals (x) when the ink was dissolved.

(13) Water Repellency (Measurement of Angle of Contact)

The angles of contact between water and surfaces of cured layers (coating layers) of the plastic labels were measured according to JIS R 3257-6. A sample having an angle of contact of 90 degrees or more was evaluated as having good water repellency (o), and one having an angle of contact of less than 90 degrees was evaluated as having poor water repellency (×).

(14) Suitability for shrinking

Plastic labels were detached from the labeled containers prepared according to the examples and comparative examples, and cured layers (coating layers) in portions which had been attached to bodies of the containers were observed upon whether or not there were delamination or crack (large crack) of the ink, whitening (fine cracking) in the case of a clear coating ink, and transfer (migration) of the coating layer to the container. The observations were performed on the labels for ten-containers of each of examples and comparative examples. The labels for ten-containers showing no defect such as cracking were evaluated as having good suitability for shrinking (o), and the label for at least one container showing any defect such as cracking was evaluated as having poor suitability for shrinking (×).

Examples are shown below.

EXAMPLE 33

The resin composition (white ink) was prepared by dispersing and mixing components in a disperser for 30 minutes. The components were 34 parts by weight of 3-ethyl-3-hydroxymethyloxetane (product of Toagosei Co., Ltd. under the trade name of "ARON OXETANE OXT-101") as Component A (A2); 15 parts by weight of 3,4-epoxycyclohexylmethyl-3',4'-epoxycyclohexanecarboxylate (product of Daicel Chemical Industries, Ltd. under the trade name of "Celloxide 2021") as Component B (B2); 3 parts by weight of a silicone modified with epoxy at both terminals (product of Shin-Etsu Chemical Co., Ltd. under the trade name of "X-22-169B": alicyclic epoxy group, epoxy equivalent: 1700) as Component C (C14); 3 parts by weight of a photoinitiator (product of Asahi Denka Kogyo K.K. under the trade name of "ADEKA OPTOMER SP-150"); 1 part by weight of a photosensitizer (product of Nippon Kayaku Co., Ltd. under the trade name of "KAYACURE-DETX-S"); 40 parts by weight of titanium dioxide (product of Ishihara Sangyo Kaisha, Ltd. under the trade name of "TIPAQUE PF-736") as a white pigment; and 1 part by weight of silica (product of Tosoh Silica Corporation under the trade name of "NIPGEL AY-401") and 3 parts by weight of an oxidized polyethylene wax (product of Mitsui Chemicals, Inc. under the trade name of "MITSUI HI-WAX 220MP") as lubricants. No solvent was used herein.
The resin composition as an ink was applied to a gravure cylinder with 60 lines/cm and a cell depth of 40 $\mu$m in a bench gravure printing machine (product of Nissio Gravure Co., Ltd. under the trade name of "GRAVO PROOF MINI"), the cylinder was rotated five times to conform the ink therewith. Then, the ink was applied onto a rectangular piece of a polyester shrink film (product of Toyobo Co., Ltd. under the trade name of "Spaceclean (S7042)"; film thickness: 50 $\mu$m) through gravure printing at a process speed of 50 m/minute.
Next, curing with ultraviolet rays was conducted with an ultraviolet irradiator having an electrode lamp (product of GS Yuasa Lighting Ltd. under the trade name of "4-kW One-lamp Conveyer CSOT-40") at a process speed of 30 m/minute, an irradiation distance of 8 cm, and an output of 3 kW. Thus, a plastic label was prepared.
Subsequently, a labeled container was prepared in the following manner. The plastic label was formed into a round cylinder so that the printed surface constituted an inner side, the length in circumferential direction of the cylinder was

adjusted so that the label would be attached to a body of a PET bottle with thermal shrinkage of 20%, both ends of the label were fused and adhered with each other to yield a cylindrical plastic label. The cylindrical plastic label was attached to a 500-ml PET bottle, subjected to shrinking of the film by immersing in hot water at 90°C for 20 seconds, and thereby yielded the labeled container.
As is shown in Table 5, the resin composition was good in processability such as gravure printability and curability, and the plastic label excelled in properties typically in scratch resistance, resistance to chemicals, and overprintability.

EXAMPLE 34

The resin composition, a plastic label, and a labeled container were prepared by the procedure of Example 33, except for using a silicone modified with epoxy in its side chain (product of Shin-Etsu Chemical Co., Ltd. under the trade name of "KF-102"; alicyclic epoxy group, epoxy equivalent: 3600) as Component C (C15) as shown in Table 5.
The resin composition was good in processability such as gravure printability and curability, and the plastic label excelled in properties such as scratch resistance, resistance to chemicals, and overprintability as demonstrated in Table 5.

EXAMPLE 35

The resin composition, a plastic label, and a labeled container were prepared by the procedure of Example 33, except for using a silicone modified with epoxy at both terminals (product of Shin-Etsu Chemical Co., Ltd. under the trade name of "X-22-163B"; aliphatic epoxy group (glycidyl-type), epoxy equivalent: 1750) as Component C (C16) as shown in Table 5.
The resin composition was good in processability such as gravure printability and curability, and the plastic label excelled in properties such as scratch resistance, resistance to chemicals, and overprintability as demonstrated in Table 5.

EXAMPLE 36

The resin composition, a plastic label, and a labeled container were prepared by the procedure of Example 33, except for changing the amounts of Component A and Component C as shown in Table 5.
The resin composition was good in processability such as gravure printability and curability, and the plastic label excelled in properties such as scratch resistance, resistance to chemicals, and overprintability as demonstrated in Table 5.

EXAMPLE 37

The resin composition, a plastic label, and a labeled container were prepared by the procedure of Example 33, except for changing the amount of Component C as shown in Table 5.
The resin composition had a high viscosity and was somewhat inferior in gravure printability at a high speed to that in Example 33, but the plastic label excelled in properties in scratch resistance, resistance to chemicals, and overprintability, as shown in Table 5.

EXAMPLE 38

The resin composition (clear coating composition) was prepared by the procedure of Example 33, except for changing the amounts of Component A and Component B, and for not using titanium dioxide as shown in Table 5. Then, a plastic label and a labeled container were prepared by the procedure of Example 33.
The resin composition was good in processability such as gravure printability and curability, and the plastic label excelled in properties such as scratch resistance, resistance to chemicals, and overprintability as demonstrated in Table 5.

EXAMPLE 39

A plastic label and a labeled container were prepared by using the resin composition prepared according to EXAMPLE 33 and curing the composition through irradiation with electron beams instead of ultraviolet rays. The irradiation with electron beams was carried out in one pass with an electron beam radiator (product of Iwasaki Electric Co., Ltd. under the trade name of "CB250/30/20 mA") at an acceleration voltage of 150 kV, a beam current of 3.5 mA, a conveyer speed of 20 m/minute, a dose of 15 kGy, and an oxygen concentration of 500 ppm.
The resin composition was good in processability such as gravure printability and curability, and the plastic label excelled in properties such as scratch resistance, resistance to chemicals, and overprintability as demonstrated in Table 5.

EXAMPLE 40

A plastic label and a labeled container were prepared by the procedure of Example 33, except for using a polyolefin shrink film (product of Gunze Packaging Systems Co., Ltd. under the trade name of "FL2"; film thickness: 50 μm) as a plastic film.
The resin composition was good in processability such as gravure printability and curability, and the plastic label excelled in properties such as scratch resistance, resistance to chemicals, and overprintability as demonstrated in Table 5.

COMPARATIVE EXAMPLE 10

The resin composition, a plastic label, and a labeled container were prepared by the procedure of Example 33, except for not using Component C and for changing the amount of Component A as shown in Table 5.
The cured layer was poor in toughness, resistance to chemicals, and water repellency, and the plastic label and labeled container were poor in properties as being susceptible to ink cracking, and also poor in overprintability as demonstrated in Table 5.

COMPARATIVE EXAMPLE 11

The resin composition was prepared by the procedure of Example 33, except for not using Component B and for changing the amount of Component A as shown in Table 5.
As demonstrated in Table 5, a plastic label and a labeled container were not obtained, because the coating layer in this comparative example did not sufficiently cure by the application of ultraviolet rays and showed tackiness.

COMPARATIVE EXAMPLE 12

The resin composition, a plastic label, and a labeled container were prepared by the procedure of Example 33, except for using a regular straight-chain silicone (straight silicone) (product of Shin-Etsu Chemical Co., Ltd. under the trade name of "KF-96-50CS") as Component C (C17) instead of the epoxy-modified silicone.
The cured layer was poor in toughness and resistance to chemicals, and the plastic label and labeled container were poor in properties as being susceptible to ink cracking, and also poor in overprintability as demonstrated in Table 5.

COMPARATIVE EXAMPLE 13

The resin composition was prepared by the procedure of Example 2 in Japanese Unexamined Patent Application Publication (JP-A) No. H11-140279, using 75 parts by weight of 3-ethyl-3-[(phenoxy)methyl]oxetane (product of Toagosei Co., Ltd. under the trade name of "ARON OXETANE OXT-211") (A3); 25 parts by weight of a bisphenol-A epoxy compound (product of Tohto Kasei Co., Ltd. under the trade name of "YD-128") (B3); and 2 parts by weight of a photoinitiator (product of The Dow Chemical Company under the trade name of "CYRACURE UVI-6992").
The resin composition had a high viscosity and failed to yield a coating layer by gravure printing as demonstrated in Table 5.

[Table 5]

(Table 5)

| | | | Example 33 | Example 34 | Example 35 | Example 36 | Example 37 | Example 38 | Example 39 | Example 40 | Comp. Ex. 10 | Comp. Ex. 11 | Comp. Ex.12 | Comp. Ex. 13 |
|---|---|---|---|---|---|---|---|---|---|---|---|---|---|---|
| Amount | Component A (oxetane compound) | A2 | 34 | 34 | 34 | 36.5 | 34 | 65 | 34 | 34 | 37 | 49 | 34 | |
| | | A3 | | | | | | | | | | | | 75 |
| | Component B (epoxy compound) | B2 | 15 | 15 | 15 | 15 | 15 | 24 | 15 | 15 | 15 | 0 | 15 | |
| | | B3 | | | | | | | | | | | | 25 |
| | Component C (epoxy-modified silicone) | C14 | 3 | | | 0.5 | 20 | 3 | 3 | 3 | 0 | 3 | | 0 |
| | | C15 | | 3 | | | | | | | | | | |
| | | C16 | | | 3 | | | | | | | | | |
| | Straight silicone | C17 | | | | | | | | | | | 3 | |
| | Photoinitiator | | 3 | 3 | 3 | 3 | 3 | 3 | 3 | 3 | 3 | 3 | 3 | 2 |
| | Sensitizer | | 1 | 1 | 1 | 1 | 1 | 1 | 1 | 1 | 1 | 1 | 1 | 0 |
| | Pigment (white) | | 40 | 40 | 40 | 40 | 40 | 0 | 40 | 40 | 40 | 40 | 40 | 0 |
| | Lubricant | silica | 1 | 1 | 1 | 1 | 1 | 1 | 1 | 1 | 1 | 1 | 1 | 0 |
| | | polyethylene wax | 3 | 3 | 3 | 3 | 3 | 3 | 3 | 3 | 3 | 3 | 3 | 0 |
| Property | Gravure printability | | ○ | ○ | ○ | ○ | Δ | ○ | ○ | ○ | ○ | ○ | ○ | × |
| | Curability (initial tack) | | ○ | ○ | ○ | ○ | ○ | ○ | ○ | ○ | ○ | × | ○ | - |
| | Adhesion (tape peeling) | | ○ | ○ | ○ | Δ | ○ | ○ | ○ | ○ | × | - | × | - |
| | Crumpling resistance | | ○ | ○ | ○ | ○ | ○ | ○ | ○ | ○ | ○ | - | ○ | - |
| | Scratch resistance | | ○ | ○ | ○ | ○ | ○ | ○ | ○ | ○ | ○ | - | ○ | - |
| | Resistance to chemicals | | ○ | ○ | ○ | ○ | ○ | ○ | ○ | ○ | Δ | - | Δ | - |
| | Water repellency | | ○ | ○ | ○ | ○ | ○ | ○ | ○ | ○ | × | - | ○ | - |
| | Suitability for shrinking | | ○ | ○ | ○ | ○ | ○ | ○ | ○ | ○ | × | - | × | - |
| | Overprintability | | ○ | ○ | ○ | ○ | ○ | ○ | ○ | ○ | × | - | × | - |

Industrial Applicability

The active energy ray-curable resin composition for the plastic film according to the present invention has low viscosity and is thereby satisfactorily applied to the plastic film typically through gravure printing or flexographic printing. The composition is cured rapidly to attain high productive efficiency of plastic labels. The composition excels in adhesion to plastic films, and after curing, it gives a resin layer that satisfactorily follows the deformation of base film during shrinking process and excels in scratch resistance and crumpling resistance. In addition, it excels in resistance to chemicals and in adhesion to another ink composition (recoatability) if overcoated. Accordingly, the resin composition according to the present invention is particularly useful typically as printing inks for the production of plastic labels. Plastic labels bearing coatings of the resin composition are particularly useful as labels to be applied typically to glass bottles, plastic containers such as PET bottles, and metallic containers such as bottle cans.

## Claims

**1.** Active energy ray-curable resin composition for a plastic film, comprising an oxetane compound, an epoxy compound, and at least one silicone compound selected from the group consisting of epoxy-modified silicones, fluorine-modified silicones, amino-modified silicones, and (meth)acrylic-modified silicones,
wherein the resin composition comprises a solvent in a content of 5 percent by weight or less.

**2.** Active energy ray-curable resin composition for a plastic film, according to claim 1, wherein the resin composition comprises the oxetane compound and the epoxy compound in a weight ratio of 2:8 to 8:2 and comprises 0.1 to 40 parts by weight of the silicone compound to 100 parts by weight of a total amount of the oxetane compound and the epoxy compound.

**3.** Active energy ray-curable resin composition for a plastic film, according to one of claims 1 and 2, comprising 10 to 75 percent by weight of the oxetane compound, 5 to 35 percent by weight of the epoxy compound, and 0.1 to 20 percent by weight of the epoxy-modified silicone.

**4.** A plastic label comprising the plastic film and a coating arranged on at least one side of the plastic film, wherein the coating is comprised of the active energy ray-curable resin composition for the plastic film of any one of claims 1 to 3.

**5.** Active energy ray curable resin composition for a plastic film, according to any one of claims 1 to 3, wherein the plastic film is a shrink film.

**6.** A plastic label according to claim 4, wherein the plastic label is a shrink label with the plastic film being a shrink film.

## Patentansprüche

**1.** Durch aktive Energiestrahlung härtbare Harzzusammensetzung für eine Kunststofffolie, umfassend eine Oxetanverbindung, eine Epoxyverbindung und wenigstens eine Siliconverbindung, ausgewählt aus der Gruppe bestehend aus Epoxy-modifizierten Siliconen, Fluor-modifizierten Siliconen, Amino-modifizierten Siliconen und (Meth)acryl-modifizierten Siliconen,
wobei die Harzzusammensetzung ein Lösungsmittel in einem Gehalt von 5 Gew.-% oder weniger umfasst.

**2.** Durch aktive Energiestrahlung härtbare Harzzusammensetzung für eine Kunststofffolie nach Anspruch 1, wobei die Harzzusammensetzung die Oxetanverbindung und die Epoxyverbindung in einem Gewichtsverhältnis von 2:8 bis 8:2 umfasst und 0,1 bis 40 Gewichtsteile der Siliconverbindung auf 100 Gewichtsteile einer Gesamtmenge der Oxetanverbindung und der Epoxyverbindung umfasst.

**3.** Durch aktive Energiestrahlung härtbare Harzzusammensetzung für eine Kunststofffolie nach einem der Ansprüche 1 und 2, umfassend 10 bis 75 Gew.-% der Oxetanverbindung, 5 bis 35 Gew.-% der Epoxyverbindung und 0,1 bis 20 Gew.-% des Epoxy-modifizierten Silicons.

**4.** Kunststoffetikett, umfassend die Kunststofffolie und eine Beschichtung, die auf wenigstens einer Seite der Kunststofffolie angeordnet ist, wobei die Beschichtung sich aus der durch aktive Energiestrahlung härtbaren Harzzusammensetzung für die Kunststofffolie nach einem der Ansprüche 1 bis 3 zusammensetzt.

**5.** Durch aktive Energiestrahlung härtbare Harzzusammensetzung für eine Kunststofffolie nach einem der Ansprüche 1 bis 3, wobei die Kunststofffolie eine Schrumpffolie ist.

**6.** Kunststoffetikett nach Anspruch 4, wobei das Kunststoffetikett ein Schrumpfetikett ist, wobei die Kunststofffolie eine Schrumpffolie ist.

**Revendications**

**1.** Composition de résine durcissable par un rayonnement énergétique actif pour un film plastique, comprenant un composé oxétane, un composé époxy, et au moins un composé siliconé choisi dans l'ensemble constitué par les silicones à modification époxy, les silicones fluorées, les silicones à modification amino, et les silicones à modification (méth)acrylique, laquelle composition de résine comprend un solvant à raison de 5 % en poids ou moins.

**2.** Composition de résine durcissable par un rayonnement énergétique actif pour un film plastique selon la revendication 1, laquelle composition de résine comprend le composé oxétane et le composé époxy en un rapport en poids de 2/8 à 8/2 et comprend 0,1 à 40 parties en poids du composé siliconé pour 100 parties en poids de la quantité totale du composé oxétane et du composé époxy.

**3.** Composition de résine durcissable par un rayonnement énergétique actif pour un film plastique selon l'une des revendications 1 et 2, comprenant 10 à 75 % en poids du composé oxétane, 5 à 35 % en poids du composé époxy, et 0,1 à 20 % en poids de la silicone à modification époxy.

**4.** Etiquette plastique comprenant le film plastique et un revêtement disposé sur au moins un côté du film plastique, dans laquelle le revêtement est constitué de la composition de résine durcissable par un rayonnement énergétique actif pour un film plastique selon l'une quelconque des revendications 1 à 3.

**5.** Composition de résine durcissable par un rayonnement énergétique actif pour un film plastique selon l'une quelconque des revendications 1 à 3, dans laquelle le film plastique est un film rétractable.

**6.** Etiquette plastique selon la revendication 4, laquelle étiquette plastique est une étiquette rétractable dont le film plastique est un film rétractable.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP H11140279 A
- JP H08143806 A
- JP 2004314468 A
- JP 2003147268 A
- JP H11349895 B
- EP 0415243 A2
- EP 1153905 A1
- JP H0885775 A
- JP H08134405 A